# FASCICULE DE BREVET EUROPEEN

(11) **EP 2 603 923 B1**
(45) Date de publication et mention de la délivrance du brevet: **15.04.2015**
(21) Numéro de dépôt: 11738249.9
(22) Date de dépôt: 02.08.2011
(51) Int. Cl.: H01H 13/705, H01H 13/704, G06F 3/045

(54) **PANNEAU DE COMMANDE A TOUCHES RESISTIVES ET CAPTEURS PRECONTRAINTS**
BEDIENFELD MIT RESISTIVEN TASTEN UND VORGESPANNTEN SENSOREN
CONTROL PANEL WITH RESISTIVE KEYS AND PRESTRESSED SENSORS

(30) Priorité: 12.08.2010 FR 1056578
(43) Date de publication de la demande: 19.06.2013
(73) Titulaire: Delphi Technologies, Inc., Troy, MI 48007 (US)
(72) Inventeur: AUBERGER, Stéphane, F-67100 Strasbourg (FR); LOBSTEIN, Roland, F-67400 Illkirch (FR)
(74) Mandataire: Robert, Vincent
(86) Numéro de dépôt international: PCT/EP2011/063301
(87) Numéro de publication internationale: WO 2012/019944

(56) Documents cités:
- EP-A1- 1 030 333
- US-A1- 2002 185 361
- US-A1- 2006 102 462

## Description

### DOMAINE TECHNIQUE

La présente invention concerne un panneau de commande, notamment pour un véhicule automobile, comportant des touches résistives.

### ARRIERE-PLAN TECHNOLOGIQUE DE L'INVENTION

La présente invention concerne plus particulièrement un panneau de commande destiné à être agencé dans l'habitacle d'un véhicule automobile, notamment au tableau de bord, et qui comporte au moins un bouton de commande sous la forme d'une touche résistive prévu pour commander une fonction déterminée, par exemple pour commander la mise en marche ou l'arrêt de la fonction air conditionné.

Le panneau de commande comporte un capot qui est monté sur un support et qui est muni d'au moins une zone de détection prévue pour former un bouton de commande. Un capteur d'effort est agencé entre le capot et le support, à l'arrière de la zone de détection, de manière à produire un signal électrique de commande lorsqu'un utilisateur exerce une force d'appui suffisante sur la zone de détection.

Pour compenser les jeux mécaniques entre le capteur d'effort et la zone de détection, il est connu d'agencer une plaque d'entretoise en matériau élastomère entre le capteur d'effort et le capot qui doit permettre d'assurer en toute circonstance une transmission directe de la force d'appui tactile vers le capteur d'effort par l'intermédiaire de la plaque d'entretoise. A cet effet, la plaque d'entretoise est montée comprimée axialement entre le capteur d'effort et le capot.

Pour permettre la détection de l'appui tactile, il est nécessaire que l'épaisseur du capot dans la zone de détection soit relativement faible de manière à permettre une légère déformation élastique du capot vers le capteur lors de l'appui tactile. Or, le montage de la plaque d'entretoise en compression entre le capteur et le capot tend à provoquer une déformation permanente du capot vers l'extérieur au niveau de la plaque d'entretoise ce qui dégrade l'aspect extérieur du capot. De plus, la répartition de la pression sur la plaque d'entretoise n'est pas homogène, l'appui principal se faisant généralement sur le bord périphérique extérieur de la plaque d'entretoise.

Ces inconvénients sont particulièrement pénalisants dans des applications soumises à de grandes variations de température, comme dans un véhicule automobile, ce qui peut conduire à une perte de la pression sur la plaque d'entretoise.

Le document "US 2002/185361 A1" décrit un panneau de commande selon le préambule de la revendication 1.

### RESUME DE L'INVENTION

La présente invention vise à remédier aux inconvénients mentionnés précédemment en proposant une solution simple, efficace, et économique.

Dans ce but, l'invention propose un panneau de commande, notamment pour un véhicule automobile, comportant un capot qui est monté sur un support et qui est muni d'au moins une zone de détection d'un appui tactile formant bouton de commande, dans lequel un capteur d'effort comportant une zone sensible à la pression est agencé entre le capot et le support, à l'arrière de la zone de détection, de manière à détecter l'actionnement du bouton de commande pour produire un signal électrique de commande lorsqu'un utilisateur exerce une force d'appui tactile déterminée sur la zone de détection, la force d'appui tactile étant transmise axialement vers la zone sensible par l'intermédiaire d'une plaque d'entretoise en matériau compressible élastiquement qui est intercalée entre le capteur et le capot, caractérisé en ce que la surface intérieure du capot comporte une série d'éléments en relief qui sont répartis sur la surface intérieure du capot en vis-à-vis de la zone sensible de manière à former plusieurs zones de surpression localisée sur la plaque d'entretoise, lesdites zones de surpression localisée étant réparties régulièrement de manière que la plaque d'entretoise applique une force de précontrainte sensiblement homogène sur la zone sensible.

L'invention est particulièrement avantageuse car elle permet de réaliser un montage dans lequel la pression axiale résiduelle exercée sur le capteur d'effort au repos, c'est-à-dire en l'absence d'appui tactile, est moindre. Ainsi le capteur d'effort est monté sans compression excessive entre son support et le capot avec la plaque d'entretoise, ce qui diminue les risques de fluage des matériaux constituant l'assemblage.

Dans le cas d'un capteur d'effort fonctionnant avec une précontrainte, la précontrainte produite par l'appui de la plaque d'entretoise sur la zone sensible du capteur peut être adaptée judicieusement sur toute la surface de la plaque d'entretoise grâce aux éléments en relief, sans avoir à appliquer une pression élevée pour garantir que la précontrainte est suffisante.

Selon d'autres caractéristiques avantageuses de l'invention :
- au moins un des éléments en relief comporte une épaisseur axiale qui varie suivant une direction transversale de manière à compenser les variations d'intensité de la force d'appui au repos du capot sur la plaque d'entretoise le long de ladite direction transversale ;
- le capot comporte un profil en courbe au niveau de la zone de détection, et l'épaisseur axiale des éléments en relief varie proportionnellement à la courbure du capot par rapport au support ;
- les éléments en relief sont séparés les uns des autres par des espaces interstitiels de manière à permettre une flexion suffisante de la zone de détection du capot lorsqu'une force d'appui tactile est appliquée ;
- les éléments en relief sont constitués de nervures ;
- les éléments en relief sont agencés suivant au moins un tracé qui est sensiblement parallèle au contour extérieur de la zone sensible ;
- les éléments en relief sont réalisés d'une seule pièce avec le capot ;
- le capteur d'effort est du type à détection d'une variation de résistance électrique entre des pistes conductrices ;
- il comporte plusieurs zones de détection formant plusieurs boutons de commande associés à plusieurs capteurs d'effort, chaque capteur d'effort comportant une plaque d'entretoise et une série d'éléments en relief associés ;
- l'épaisseur axiale des éléments en relief est globalement croissante suivant la direction transversale, depuis la périphérie de la portion comportant les zones de détection jusqu'à une partie centrale de ladite portion ;
- une plaquette en matériau plus rigide que le matériau constituant la plaque d'entretoise est intercalée entre la plaque d'entretoise et la zone sensible du capteur en vue de contribuer à une répartition homogène de la force de précontrainte et de la force d'appui tactile sur la zone sensible du capteur.

### BREVE DESCRIPTION DES DESSINS

D'autres caractéristiques, buts et avantages de l'invention apparaîtront à la lecture de la description détaillée qui va suivre, et en regard des dessins annexés, donnés à titre d'exemple non limitatif et sur lesquels:
- les figures 1 et 2 sont des vues éclatées en perspective qui représentent schématiquement un panneau de commande équipé de touches résistives munies de capteurs d'effort et de plaques d'entretoise selon un premier mode de réalisation de l'invention ;
- la figure 3 est une vue partielle en coupe axiale qui représente schématiquement la structure d'un capteur d'effort équipant le panneau de commande des figures 1 et 2 ;
- la figure 4 est une vue de dessus qui représente schématiquement un film portant plusieurs capteurs d'efforts prévu équiper le panneau de commande des figures 1 et 2 ;
- la figure 5 est une vue éclatée en perspective qui représente schématiquement un deuxième mode de réalisation d'un panneau de commande conforme aux enseignements de l'invention ;
- la figure 6 est une vue en coupe axiale selon le plan 6-6 de la figure 5 qui représente schématiquement le capot du panneau de commande de la figure 5 et les éléments en relief qui l'équipent ;
- la figure 7 est un schéma illustrant la répartition de la pression exercée par le capot sur la plaque d'entretoise d'un capteur d'effort dans le cadre d'un panneau de commande de l'art antérieur ;
- la figure 8 est un schéma similaire à celui de la figure 7 illustrant la répartition de la pression exercée par le capot sur la plaque d'entretoise d'un capteur d'effort dans le cadre du panneau de commande selon le deuxième mode de réalisation de l'invention représenté sur la figure 5 ;
- la figure 9 est une vue en perspective du dessous du capot d'un panneau de commande selon un troisième mode de réalisation dans lequel l'épaisseur axiale des éléments en relief varie ;
- la figure 10 est une vue en coupe axiale selon le plan 10-10 de la figure 9 qui représente schématiquement le capot du panneau de commande de la figure 9;
- les figures 11 et 12 sont des vue en perspective du dessous du capot d'un panneau de commande selon des variantes de réalisation dans lesquelles la disposition des éléments en relief est différente.

### DESCRIPTION DES MODES DE REALISATION PREFERES

Dans la suite de la description, des éléments identiques ou similaires pourront être désignés par des références identiques.

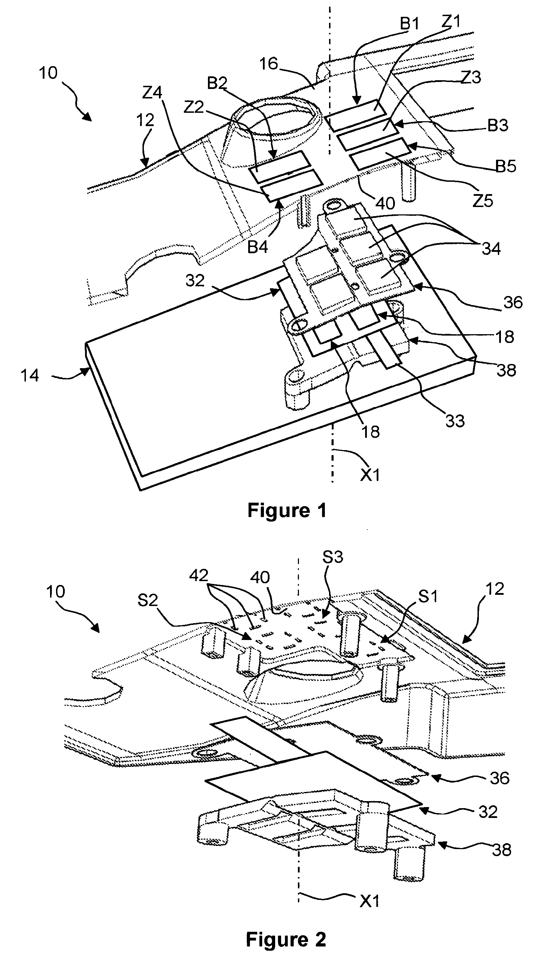

Sur les figures 1 et 2, on a représenté un panneau de commande 10 pour un tableau de bord de véhicule automobile réalisé selon un premier mode de réalisation conforme aux enseignements de l'invention. Il comporte ici un capot 12 qui est monté sur un support 14, la surface extérieure 16 du capot 12 comportant plusieurs zones de détection Z1, Z2, Z3, Z4, Z5 d'un appui tactile formant plusieurs boutons de commande B1, B2, B3, B4, B5, ou touches résistives.

Dans la suite de la description, on utilisera à titre non limitatif une orientation axiale suivant un axe X1 sensiblement orthogonal au plan général du capot 12, orienté du bas vers le haut, c'est-à-dire depuis le support 14 vers la surface extérieure 16 du capot 12, ce qui correspond globalement à une orientation du bas vers le haut en considérant les figures 1 et 2.

Chaque bouton de commande B1, B2, B3, B4, B5 comporte ici un capteur d'effort 18 qui est agencé entre le capot 12 et le support 14, à l'arrière et axialement en vis-à-vis de la zone de détection Z1, Z2, Z3, Z4, Z5 associée. Chaque capteur d'effort 18 est prévu pour détecter l'actionnement du bouton de commande B1, B2, B3, B4, B5 associé pour produire un signal électrique de commande lorsqu'un utilisateur exerce une force d'appui tactile d'intensité suffisante sur la zone de détection Z1, Z2, Z3, Z4, Z5 associée.

Selon une caractéristique avantageuse de l'invention, chaque capteur d'effort 18 est du type à résistance variable en fonction de l'effort, par exemple du type FSR (Force Sensing Resistor) comme décrit et représenté dans les documents US2006/0007172A1 et WO2009/070503A1.

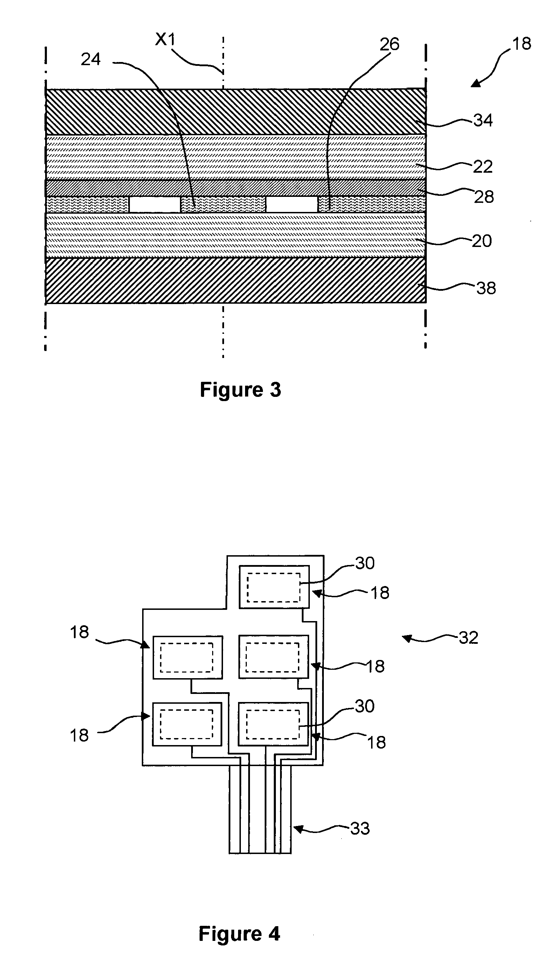

De préférence, on utilise ici un capteur d'effort 18 monté sous précontrainte mécanique, comme on l'a représenté sur les figures 3 et 4. Le capteur d'effort 18 comporte ici un premier 20 et un second 22 substrats dont l'un au moins est flexible lorsqu'une force d'appui tactile est exercée sur la zone de détection Z1, Z2, Z3, Z4, Z5 associée. Des pistes conductrices électriques 24, 26 sont agencées, par exemple sous la forme de peignes interdigités, sur une face du premier substrat 20 en vis-à-vis d'un revêtement résistif 28 agencé sur la face en vis-à-vis du second substrat 22, de manière à définir une zone sensible à la pression 30 qui est globalement superposée à la zone de détection Z1, Z2, Z3, Z4, Z5 associée. A l'état de repos du capteur d'effort 18, en l'absence de force d'appui tactile, le revêtement résistif 28 est en contact électrique avec des portions de pistes conductrices 24, 26.

De manière avantageuse, les cinq boutons de commande B1, B2, B3, B4, B5 étant positionnés de manière sensiblement adjacente sur le capot 12, il est possible d'agencer les cinq capteurs d'effort 18 associés sur les mêmes substrats 20, 22. Ainsi, comme représenté sur les figures 1, 2, et 4, les capteurs d'effort 18 se présentent sous la forme d'un film 32 comportant une nappe 33 de raccordement électrique prévue pour permettre le raccordement des cinq capteurs 18 à une unité électronique de commande (non représentée).

Selon le mode de réalisation représenté, une plaque d'entretoise 34 en matériau compressible élastiquement est montée entre chaque capteur 18 et le capot 12, en vis-à-vis de la zone de détection Z1, Z2, Z3, Z4, Z5 de manière à rattraper les jeux mécaniques entre le capteur 18 et le capot 12. De préférence, les cinq plaques d'entretoise 34 prévues pour les cinq capteurs 18 sont toutes formées par moulage dans une même plaquette 36 en silicone ou en matériau élastomère.

On note que, du fait de la rigidité du capot 12 au niveau de la zone de détection Z1, Z2, Z3, Z4, Z5, les jeux de fonctionnement, c'est-à-dire les déplacements axiaux du capot 12 au niveau de la zone de détection, peuvent être inférieurs aux jeux mécaniques. La plaque d'entretoise 44 permet donc de rattraper les jeux mécaniques pour permettre la détection des déplacements axiaux X1 du capot 12 dus à des appuis tactiles.

Selon le mode de réalisation représenté, une platine intermédiaire 38 est agencée entre le support 14 du capot 12 et le film 32 portant les capteurs d'effort 18. La platine intermédiaire 38, qui est fixée sur le support 14, constitue un support pour les capteurs d'effort 18. Elle est réalisée de préférence dans un matériau suffisamment rigide, par exemple du polycarbonate (PC) ou du polymétacrylate de méthyle (PMMA) pour permettre le montage des capteurs d'effort 18 en précontrainte, c'est-à-dire pour permettre de comprimer axialement les capteurs d'effort 18 entre la platine intermédiaire 38 et le capot 12, avec interposition de la plaquette 36 entre les capteurs d'effort 18 et le capot 12.

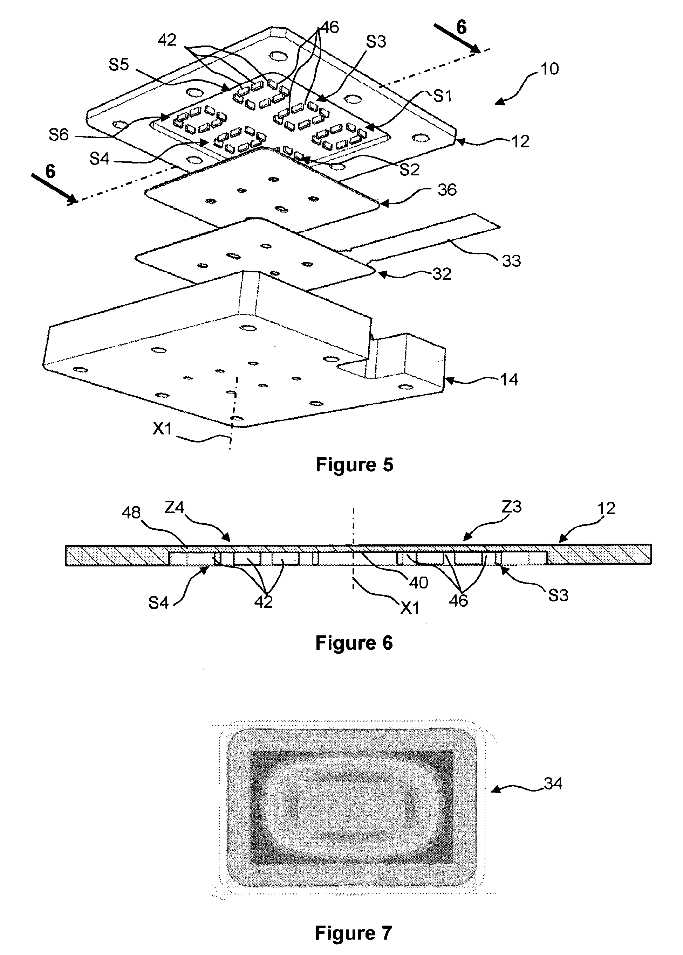

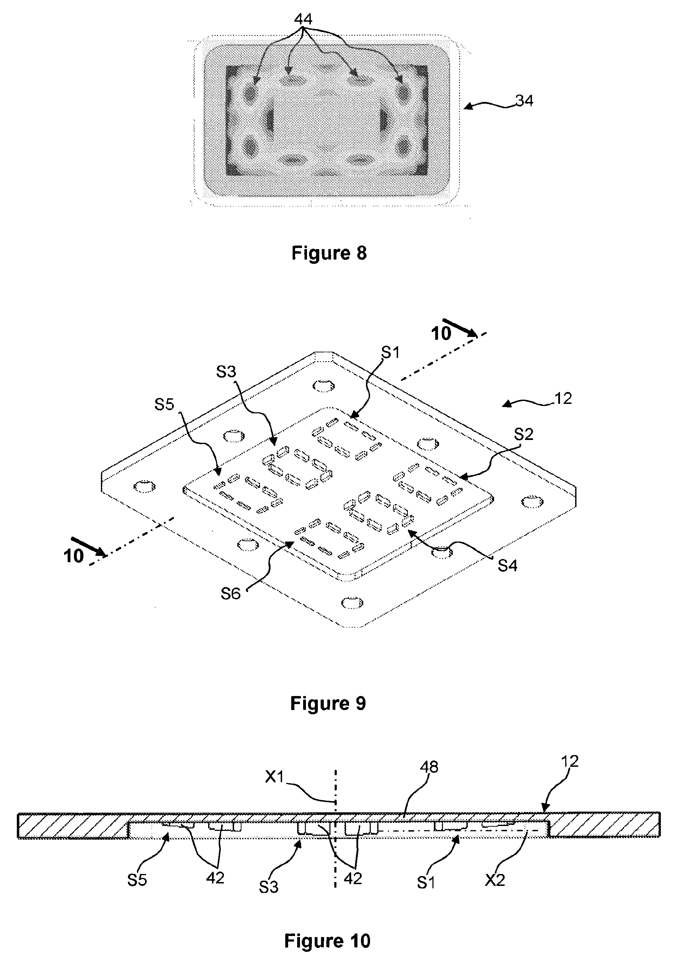

Conformément aux enseignements de l'invention, la surface intérieure 40 du capot 12 comporte une série S1, S2, S3, S4, S5 d'éléments en relief 42 qui sont répartis sur la surface intérieure du capot 12, en vis-à-vis de la zone sensible 30, de manière à former plusieurs zones de surpression localisée 44 sur la plaque d'entretoise 34, comme cela sera expliqué plus en détail en relation avec les figures 7 et 8 et avec le second mode de réalisation représenté sur la figure 5.

Sur les figures 5 et 6, on a représenté schématiquement un deuxième mode de réalisation du panneau de commande 10 selon l'invention dans lequel le montage des capteurs d'effort 18 est simplifié du fait que le film 32 muni des capteurs d'effort 18 repose directement sur la face supérieure du support 14. Par ailleurs, la forme générale du panneau de commande 10 est ici globalement parallélépipédique ce qui permet de mettre en évidence les caractéristiques de l'invention. Bien entendu, le panneau de commande 18 peut revêtir toute forme adaptée à son agencement dans l'habitacle d'un véhicule.

Dans l'exemple de réalisation représenté, le panneau de commande 10 comporte six zones de détection Z1, Z2, Z3, Z4, Z5, Z6 et donc six séries S1, S2, S3, S4, S5, S6 d'éléments en relief 42 associées. Les zones de détection sont ici toutes identiques et de forme rectangulaire. Bien entendu, le panneau de commande 10 pourrait comporter des zones de détection de formes distinctes, ces formes devant notamment être adaptées aux besoins d'ergonomie des commandes.

La figure 7 illustre la répartition de la pression appliquée par un capot 12 conventionnel, dépourvu d'éléments en relief, sur une plaque d'entretoise 34 et la figure 8 illustre la répartition de la pression appliquée par le capot 12 équipé des éléments en relief 42 selon l'invention sur la plaque d'entretoise 34. Comme on peut le voir, dans le cas de l'art antérieur, la pression s'applique majoritairement sur le pourtour de la plaque d'entretoise 34 et en quatre points localisés à proximité du centre de la plaque d'entretoise 34. Au contraire, dans le cas de l'invention, la répartition de la pression sur la plaque d'entretoise 34 est mieux répartie du fait de la multiplicité des éléments en relief 42 dont le positionnement et la répartition sont choisis de façon à optimiser la répartition de la pression et permettre ainsi à la plaque d'entretoise 34 d'appliquer une pression sensiblement homogène sur la zone sensible 30 du capteur de pression 18. Ainsi, dans l'exemple représenté, les éléments en relief 42 sont réalisés sous la forme de nervures espacées les unes des autres et agencées selon un tracé rectangulaire sensiblement parallèle au contour rectangulaire de la plaque d'entretoise 34 et de la zone sensible 30. Il y a ici huit nervures qui produisent huit zones de surpression localisée 44.

Grâce à la répartition des éléments en relief 42 et donc à la répartition optimisée des zones de surpression localisée 44, l'effort de précontrainte appliqué par la plaque d'entretoise 34 sur la zone sensible 30 du capteur d'effort 18 est plus homogène. L'élasticité et la flexibilité du matériau constituant la plaque d'entretoise 34 contribuent à transmettre et répartir de manière sensiblement homogène l'effort de précontrainte depuis le capot 12 et ses éléments en relief 42 vers la zone sensible 30.

Avantageusement, les espaces interstitiels 46 entre les éléments en relief 42 sont prévus pour permettre une flexion suffisante de la zone de détection Z1, Z2, Z3, Z4, Z5, Z6 du capot 12 lorsqu'une force d'appui tactile est appliquée, en évitant aux éléments en relief 42 de rigidifier excessivement le capot 12 dans la zone de détection Z1, Z2, Z3, Z4, Z5, Z6.

Le nombre et les dimensions des éléments en relief 42 et des espaces interstitiels 46 peuvent être adaptés en fonction des besoins de répartition de pression et de flexibilité de la zone de détection Z1, Z2, Z3, Z4, Z5, Z6.

Comme on peut le voir sur la figure 6, le capot 12 comporte une portion amincie 48, définissant ici une zone rectangulaire où sont agencées les zones de détection Z1, Z2, Z3, Z4, Z5, Z6 adjacentes. Cette portion amincie 48 offre une flexibilité supérieure aux autres zones du capot 12 pour permettre la détection des appuis tactile par les capteurs d'effort 18.

Du fait de la localisation des points de fixation du capot 12 sur le support 14 sur le pourtour de la portion amincie 48 et du fait de la flexibilité de cette portion amincie 48 qui se déforme, la pression appliquée par le capot 12 sur les plaques d'entretoise 34 tend à être plus élevée à la périphérie de la portion amincie 48 par rapport au centre de la portion amincie 48.

Aussi, pour améliorer encore l'homogénéité de la force de précontrainte sur les capteurs d'effort 18, l'invention propose dans un troisième mode de réalisation représenté sur les figures 9 et 10, d'adapter l'épaisseur axiale des éléments en relief 42 en fonction de leur position par rapport à la périphérie de la portion amincie 48. Ainsi, en considérant la vue en coupe axiale de la figure 10, on constate que dans chaque série S1, S3, S5, l'épaisseur axiale des nervures 42 est croissante suivant une direction transversale X2 depuis la périphérie de la portion amincie 48 jusqu'à son centre. Cet agencement selon l'invention permet de compenser les différences de pression appliquées par le capot 12 sur les plaques d'entretoise 34.

Selon une variante de réalisation (non représentée), l'épaisseur des éléments en relief 42 peut aussi être adaptée de manière à compenser les effets d'une courbure du capot 12 dans le cas d'un capot 12 ayant un profil transversal particulier non rectiligne.

De préférence, les éléments en relief 42 sont réalisés d'une seule pièce avec le capot 12, par exemple par moulage.

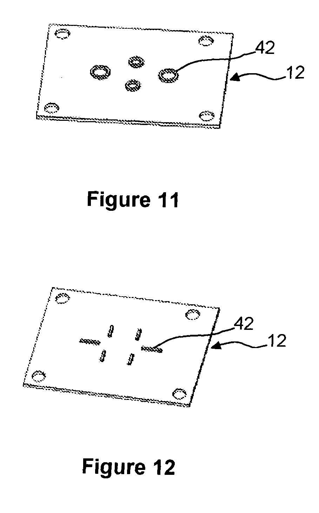

Selon des variantes de réalisation, représentées notamment sur les figures 11 et 12, les éléments en relief 42 peuvent avoir différentes formes, par exemple la forme de nervures agencées en cercle, comme sur la figure 11, ou de nervures agencées en croix, comme sur la figure 12.

Les éléments en relief 42 pourraient prendre des formes autres que les nervures. Toutefois, le choix de nervures présente l'avantage de permettre une fabrication facile, y compris par moulage, tout en permettant une certaine précision et une grande liberté dans le positionnement des zones de surpression localisée 44. De plus, les nervures permettent d'obtenir ces effets sans provoquer une rigidification pénalisante du capot 12 au niveau des zones de détection Z1, Z2, Z3, Z4, Z5, Z6.

Avantageusement, pour obtenir une répartition de la pression sur la zone sensible 30 encore plus homogène, chaque plaque d'entretoise 34 peut être pourvue sur sa face inférieure d'une plaquette en matériau plus rigide que le matériau constituant la plaque d'entretoise 34. La plaquette est par exemple réalisée en matériau thermoplastique relativement rigide, par rapport au matériau élastomère constituant la plaque d'entretoise 34. La plaquette peut être réalisée par surmoulage avec ladite plaque d'entretoise 34. Chaque plaquette s'étend globalement sur toute l'aire de la zone sensible 30 associée pour répartir la pression sur l'ensemble de la zone sensible 30.

Le panneau de commande 10 a été décrit ici avec plusieurs boutons de commande B1, B2, B3, B4, B5. Bien entendu, l'invention s'applique aux variantes de réalisation qui comporteraient un seul bouton de commande ou un nombre différent de boutons de commande.

## Revendications

1. Panneau de commande (10), notamment pour un véhicule automobile, comportant un capot (12) qui est monté sur un support (14) et qui est muni d'au moins une zone de détection (Z1, Z2, Z3, Z4, Z5, Z6) d'un appui tactile formant bouton de commande (B1, B2, B3, B4, B5), dans lequel un capteur d'effort (18) comportant une zone sensible à la pression (30) est agencé entre le capot (12) et le support (14), à l'arrière de la zone de détection (Z1, Z2, Z3, Z4, Z5, Z6), de manière à détecter l'actionnement du bouton de commande (B1, B2, B3, B4, B5) pour produire un signal électrique de commande lorsqu'un utilisateur exerce une force d'appui tactile déterminée sur la zone de détection (Z1, Z2, Z3, Z4, Z5, Z6), la force d'appui tactile étant transmise axialement (X1) vers la zone sensible (30) par l'intermédiaire d'une plaque d'entretoise (34) en matériau compressible élastiquement qui est intercalée entre le capteur (18) et le capot (12),
**caractérisé en ce que** la surface intérieure (40) du capot (12) comporte une série (S1, S2, S3, S4, S5, S6) d'éléments en relief (42) qui sont répartis sur la surface intérieure du capot en vis-à-vis de la zone sensible (30) de manière à former plusieurs zones de surpression localisée (44) sur la plaque d'entretoise (34), lesdites zones de surpression localisée (44) étant réparties régulièrement de manière que la plaque d'entretoise (34) applique une force de précontrainte sensiblement homogène sur la zone sensible (30).

2. Panneau de commande (10) selon la revendication précédente, **caractérisé en ce qu'**au moins un des éléments en relief (42) comporte une épaisseur axiale qui varie suivant une direction transversale (X2) de manière à compenser les variations d'intensité de la force d'appui au repos du capot (12) sur la plaque d'entretoise (34) le long de ladite direction transversale (X2).

3. Panneau de commande (10) selon la revendication 2, dans lequel le capot (12) comporte un profil en courbe au niveau de la zone de détection (Z1, Z2, Z3, Z4, Z5, Z6), **caractérisé en ce que** l'épaisseur axiale des éléments en relief (42) varie proportionnellement à la courbure du capot (12) par rapport au support (14).

4. Panneau de commande (10) selon l'une quelconque des revendications précédentes, **caractérisé en ce que** les éléments en relief (42) sont séparés les uns des autres par des espaces interstitiels (46) de manière à permettre une flexion suffisante de la zone de détection (Z1, Z2, Z3, Z4, Z5, Z6) du capot (12) lorsqu'une force d'appui tactile est appliquée.

5. Panneau de commande (10) selon l'une quelconque des revendications précédentes, **caractérisé en ce que** les éléments en relief (42) sont constitués de nervures.

6. Panneau de commande (10) selon la revendication précédente, **caractérisé en ce que** les éléments en relief (42) sont agencés suivant au moins un tracé qui est sensiblement parallèle au contour extérieur de la zone sensible (30).

7. Panneau de commande (10) selon l'une quelconque des revendications précédentes, **caractérisé en ce que** les éléments en relief (42) sont réalisés d'une seule pièce avec le capot (12).

8. Panneau de commande (10) selon l'une quelconque des revendications précédentes, **caractérisé en ce que** le capteur d'effort (18) est du type à détection d'une variation de résistance électrique entre des pistes conductrices (24, 26).

9. Panneau de commande (10) selon l'une quelconque des revendications précédentes, **caractérisé en ce qu'**il comporte une portion (48) comportant plusieurs zones de détection (Z1, Z2, Z3, Z4, Z5, Z6) formant plusieurs boutons de commande (B1, B2, B3, B4, B5) sensiblement adjacents associés à plusieurs capteurs d'effort (18), chaque capteur d'effort (18) comportant une plaque d'entretoise (34) et une série (S1, S2, S3, S4, S5, S6) d'éléments en relief (42) associés.

10. Panneau de commande (10) selon la revendication précédente, **caractérisé en ce que** l'épaisseur axiale des éléments en relief (42) est globalement croissante suivant la direction transversale (X2), depuis la périphérie de la portion (48) comportant les zones de détection (Z1, Z2, Z3, Z4, Z5, Z6) jusqu'à une partie centrale de ladite portion (48).

11. Panneau de commande (10) selon l'une quelconque des revendications précédentes, **caractérisé en ce qu'**une plaquette en matériau plus rigide que le matériau constituant la plaque d'entretoise (34) est intercalée entre la plaque d'entretoise (34) et la zone sensible (30) du capteur (18) en vue de contribuer à une répartition homogène de la force de précontrainte et de la force d'appui tactile sur la zone sensible (30) du capteur (18).

## Patentansprüche

1. Bedienfeld (10), insbesondere für ein Kraftfahrzeug, enthaltend eine Abdeckung (12), die an einem Träger (14) montiert ist und mit zumindest einem Erfassungsbereich (Z1, Z2, Z3, Z4, Z5, Z6) zum Erfassen einer physischen Berührung ausgestattet ist, der eine Steuertaste (B1, B2, B3, B4, B5) darstellt, wobei ein Kraftsensor (18) mit einem druckempfindlichen Bereich (30) zwischen der Abdeckung (12) und dem Träger (14) auf der Hinterseite des Erfassungsbereichs (Z1, Z2, Z3, Z4, Z5, Z6) so angeordnet ist, dass die Betätigung der Steuertaste (B1, B2, B3, B4, B5) erfasst wird, um ein elektrisches Steuersignal dann zu erzeugen, wenn ein Benutzer eine bestimmte Berührungskraft auf den Erfassungsbereich (Z1, Z2, Z3, Z4, Z5, Z6) ausübt, wobei die Berührungskraft axial (X1) auf den empfindlichen Bereich (30) über eine Verstrebungsplatte (34) aus elastisch zusammendrückbarem Material übertragen wird, die zwischen dem Sensor (18) und der Abdeckung (12) eingesetzt ist,
**dadurch gekennzeichnet, dass** die Innenfläche (40) der Abdeckung (12) eine Reihe (S1, S2, S3, S4, S5, S6) von erhabenen Elementen (42) aufweist, die dem empfindlichen Bereich (30) gegenüberliegend über die Innenfläche der Abdeckung verteilt sind, so dass sie mehrere eingegrenzte Überdruckbereiche (44) an der Verstrebungsplatte (34) bilden, wobei die eingegrenzten Überdruckbereiche (44) gleichmäßig verteilt sind, so dass die Verstrebungsplatte (34) eine im Wesentlichen gleichmäßige Vorspannkraft auf den empfindlichen Bereich (30) aufbringt.

2. Bedienfeld (10) nach dem vorangehenden Anspruch, **dadurch gekennzeichnet, dass** zumindest eines der erhabenen Elemente (42) eine axiale Dicke aufweist, die in einer Querrichtung (X2) variiert, so dass in Ruhestellung Schwankungen in der Stärke der Andrückkraft der Abdeckung (12) auf die Verstrebungsplatte (34) in der Querrichtung (X2) kompensiert werden.

3. Bedienfeld (10) nach Anspruch 2, wobei die Abdeckung (12) ein Kurvenprofil in der Nähe des Erfassungsbereichs (Z1, Z2, Z3, Z4, Z5, Z6) aufweist, **dadurch gekennzeichnet, dass** die axiale Dicke der erhabenen Elemente (42) proportional zur Krümmung der Abdeckung (12) bezüglich des Trägers (14) variiert.

4. Bedienfeld (10) nach einem der vorangehenden Ansprüche, **dadurch gekennzeichnet, dass** die erhabenen Elemente (42) durch Zwischenräume (46) voneinander getrennt sind, so dass eine ausreichende Biegung des Erfassungsbereichs (Z1, Z2, Z3, Z4, Z5, Z6) der Abdeckung (12) dann möglich ist, wenn eine Berührungskraft aufgebracht wird.

5. Bedienfeld (10) nach einem der vorangehenden Ansprüche, **dadurch gekennzeichnet, dass** die erhabenen Elemente (42) aus Rippen bestehen.

6. Bedienfeld (10) nach einem der vorangehenden Ansprüche, **dadurch gekennzeichnet, dass** die erhabenen Elemente (42) entlang zumindest einer Bahn angeordnet sind, die im Wesentlichen parallel zur Außenkontur des empfindlichen Bereichs (30) verläuft.

7. Bedienfeld (10) nach einem der vorangehenden Ansprüche, **dadurch gekennzeichnet, dass** die erhabenen Elemente (42) aus einem Stück mit der Abdeckung (12) ausgebildet sind.

8. Bedienfeld (10) nach einem der vorangehenden Ansprüche, **dadurch gekennzeichnet, dass** der Kraftsensor (18) zum Erfassen einer Schwankung des elektrischen Widerstands zwischen Leiterbahnen (24, 26) ausgeführt ist.

9. Bedienfeld (10) nach einem der vorangehenden Ansprüche, **dadurch gekennzeichnet, dass** es einen Abschnitt (48) mit mehreren Erfassungsbereichen (Z1, Z2, Z3, Z4, Z5, Z6) aufweist, die mehrere Steuertasten (B1, B2, B3, B4, B5) darstellen, die im Wesentlichen aneinandergrenzen und denen mehrere Kraftsensoren (18) zugeordnet sind, wobei jeder Kraftsensor (18) eine Verstrebungsplatte (34) und eine Reihe (S1, S2, S3, S4, S5, S6) von zugeordneten erhabenen Elementen (42) aufweist.

10. Bedienfeld (10) nach dem vorangehenden Anspruch, **dadurch gekennzeichnet, dass** die axiale Dicke der erhabenen Elemente (42) in Querrichtung (X2) ausgehend vom Umfang des Abschnitts (48) mit den Erfassungsbereichen (Z1, Z2, Z3, Z4, Z5, Z6) bis zu einem mittleren Teil des Abschnitts (48) zunimmt.

11. Bedienfeld (10) nach einem der vorangehenden Ansprüche, **dadurch gekennzeichnet, dass** eine Scheibe aus einem steiferen Material als das die Verstrebungsplatte (34) bildende Material zwischen der Verstrebungsplatte (34) und dem empfindlichen Bereich (30) des Sensors (18) eingesetzt ist, um zu einer gleichmäßigen Verteilung der Vorspannkraft und der Berührungskraft auf dem empfindlichen Bereich (30) des Sensors (18) beizutragen.

## Claims

1. Control panel (10), in particular for a motor vehicle, including a cover (12) which is mounted on a support (14) and which is provided with at least one tactile pressing detection zone (Z1, Z2, Z3, Z4, Z5, Z6) forming a control button (B1, B2, B3, B4, B5), in which a force sensor (18) having a pressure-sensitive zone (30) is arranged between the cover (12) and the support (14), behind the detection zone (Z1, Z2, Z3, Z4, Z5, Z6), so as to detect the actuation of the control button (B1, B2, B3, B4, B5) to produce an electrical control signal when a user applies a determined tactile pressing force to the detection zone (Z1, Z2, Z3, Z4, Z5, Z6), the tactile pressing force being transmitted axially (X1) towards the sensitive zone (30) via a spacer plate (34) made of elastically compressible material which is intercalated between the sensor (18) and the cover (12),
**characterised by** the fact that the inner surface (40) of the cover (12) includes a series (S1, S2, S3, S4, S5, S6) of relief elements (42) which are distributed over the inner surface of the cover opposite the sensitive zone (30) so as to form a plurality of zones of localised excess pressure (44) on the spacer plate (34), the said zones of localised excess pressure (44) being uniformly distributed so that the spacer plate (34) applies a substantially even prestressing force over the sensitive zone (30).

2. Control panel (10) as described in the preceding claim, **characterised by** the fact that at least one of the relief elements (42) has an axial thickness which varies in a transversal direction (X2) so as to compensate for the variations in intensity of the pressing force at rest of the cover (12) on the spacer plate (34) in the said transversal direction (X2).

3. Control panel (10) as described in claim 2, in which the cover (12) has a curved profile in the detection zone (Z1, Z2, Z3, Z4, Z5, Z6), **characterised by** the fact that the axial thickness of the relief elements (42) varies in proportion to the curvature of the cover (12) relative to the support (14).

4. Control panel (10) as described in any one of the preceding claims, **characterised by** the fact that the relief elements (42) are separated the ones from the others by interstitial spaces (46) so as to allow sufficient flexing of the detection zone (Z1, Z2, Z3, Z4, Z5, Z6) of the cover (12) when a tactile pressing force is applied.

5. Control panel (10) as described in any one of the preceding claims, **characterised by** the fact that the relief elements (42) are formed of ribs.

6. Control panel (10) as described in the preceding claim, **characterised by** the fact that the relief elements (42) are arranged in at least one path which is substantially parallel with the outer outline of the sensitive zone (30).

7. Control panel (10) as described in any one of the preceding claims, **characterised by** the fact that the relief elements (42) are formed in one piece with the cover (12).

8. Control panel (10) as described in any one of the preceding claims, **characterised by** the fact that the force sensor (18) is of the type with detection of a variation in electrical resistance between conductive tracks (24, 26).

9. Control panel (10) as described in any one of the preceding claims, **characterised by** the fact that it includes a portion (48) including a plurality of detection zones (Z1, Z2, Z3, Z4, Z5, Z6) forming a plurality of substantially adjacent control buttons (B1, B2, B3, B4, B5) associated with a plurality of force sensors (18), each force sensor (18) including a spacer plate (34) and a series (S1, S2, S3, S4, S5, S6) of associated relief elements (42).

10. Control panel (10) as described in the preceding claim, **characterised by** the fact that the axial thickness of the relief elements (42) generally increases in the transversal direction (X2), from the periphery of the portion (48) including the detection zones (Z1, Z2, Z3, Z4, Z5, Z6) to a central part of the said portion (48).

11. Control panel (10) as described in any one of the preceding claims, **characterised by** the fact that a plate of material more rigid than the material forming the spacer plate (34) is intercalated between the spacer plate (34) and the sensitive zone (30) of the sensor (18) in order to contribute to even distribution of the prestressing force and of the tactile pressing force over the sensitive zone (30) of the sensor (18).
